# EUROPEAN PATENT APPLICATION

(11) **EP 4 411 829 A1**
(43) Date of publication of application: **07.08.2024**
(21) Application number: 23154218.4
(22) Date of filing: 31.01.2023
(51) Int. Cl.: H01L 29/78, H01L 29/08, H01L 29/10

(54) **POWER SEMICONDUCTOR DEVICE AND METHOD FOR PRODUCING A POWER SEMICONDUCTOR DEVICE**

(71) Applicant: Hitachi Energy Ltd, 8050 Zürich (CH)
(72) Inventor: DONATO, Nazareno, Norwich, Sprowston NR7 8FZ (GB); MIHAILA, Andrei, 5415 Rieden (CH); ROMANO, Gianpaolo, 5400 Baden (CH); KNOLL, Lars, 5607 Hägglingen (CH); UDREA, Florin, Cambridge, CB2 ORB (GB)
(74) Representative: Epping - Hermann - Fischer

(57) **Abstract**

A power semiconductor device (1) is specified, comprising
- a drift layer (2) of a first conductivity type,
- a well region (3) of a second conductivity type being different from the first conductivity type, and
- a first doped region (4) of the first conductivity type and a second doped region (5) of the second conductivity type, wherein
- the well region (3), the first doped region (4) and the second doped region (5) are provided at a first side of the power semiconductor device (1),
- the first doped region (4) and the second doped region (5) are spaced apart (6) from the drift layer (2) by the well region (3), and
- the second doped region (5) is completely surrounded by the first doped region (4) in lateral directions, and
- the second doped region (5) comprises at least two parts (6), which are spaced apart (6) from one another in lateral directions by the first doped region (4).

Furthermore, a method for producing a power semiconductor device (1) is specified.

## Description

The present disclosure relates to a power semiconductor device and a method for producing a power semiconductor device.

A power semiconductor device is realized e.g. as a metal-oxide-semiconductor field-effect transistor, MOSFET. The MOSFET may be based on a wide band-gap material such as e.g. silicon carbide, SiC, material. 650V and 1200V-rated SiC MOSFETs are currently commercially available. Implemented with planar and trench cell designs, SiC MOSFETs are developed for automotive and transportation applications. Compared to their Si-counterparts, SiC MOSFETs allow for an increased power density and a maximum junction temperature (Tⱼₘₐₓ) while improving an efficiency and reducing a size of a power electronic system with such SiC MOSFET. While the increased maximum junction temperature provides a useful indication of the resistance towards abnormal electrical events such as unclamped inductive switching (UIS) and Short Circuit (SC), the higher power density leads to faster thermal transients (dT/dt) and often limit the reliability of the device and the metallization and/or packaging material.

Regarding the fault handling capability, SiC MOSFETs still fall short of the typical industry standard values shown by their Si counterparts. Besides, SiC MOSFETs with reduced cell pitch and die size show reduced SC endurance time when compared with previous generations. However, such SiC MOSFETs are typically associated with a strong trade-off between conduction losses and short-circuit withstand time, SCWT.

Embodiments of the disclosure relate to a power semiconductor device, which has an improved efficiency. A further embodiment relates to a method for producing such a power semiconductor device.

This is achieved by the subject-matter of the independent claims. Further embodiments are evident from the dependent claims and the following description.

The term "power" here and in the following, for example, refers to power semiconductor devices adapted for processing voltages and currents of more than 100 V, e.g. 650 V or 1200V and/or of more than 10 A.

The power semiconductor device is, for example, a power metal insulating semiconductor field-effect transistor, power MISFET for short. The term MISFET shall also comprise MOSFETs, which have an oxide as insulating material at the gate. The power semiconductor device may also be an insulated-gate bipolar transistor, IGBT.

Exemplarily the power MISFET comprises a wide bandgap material, which can be silicon carbide, SiC. Thus, the power semiconductor device is exemplarily embodied as a power SiC MISFET, in particular a power SiC MOSFET.

According to an embodiment, the power semiconductor device comprises a drift layer of a first conductivity type. For example, the drift layer comprises a semiconductor material or consists of a semiconductor material. Exemplarily the semiconductor material is SiC. For example, the drift layer comprises first dopants, which define the first conductivity type.

The drift layer has, for example, a main extension plane. For example, lateral directions are aligned parallel to the main extension plane and a vertical direction is aligned perpendicular to the main extension plane.

In top view, along the vertical direction, the drift layer has in lateral directions, for example, a polygonal shape, such as a triangular shape, a quadrangular shape or a hexagonal shape. For example, an outer circumference of the drift layer has the polygonal shape in lateral directions.

According to the embodiment, the power semiconductor device comprises a well region of a second conductivity type being different from the first conductivity type. The well region comprises or consists of a semiconductor material, which is, for example, the same material as the semiconductor material of the drift layer. Exemplarily, the well region comprises second dopants, which define the second conductivity type.

Exemplarily, the first dopants are n-type dopants such that the first conductivity type is an n-type conductivity and the second dopants are p-type dopants such that the second conductivity type is a p-type conductivity, or vice versa. For example, the n-type conductivity is achieved by using phosphorus (P) and/or nitrogen (N) as the first dopants. The p-type conductivity is achieved by using aluminium (Al) and/or boron (B) as the second dopants.

In top view, along the vertical direction, the well region has in lateral directions, for example, a polygonal shape, such as a triangular shape, a quadrangular shape or a hexagonal shape. For example, an outer circumference of the well region has the polygonal shape in lateral directions. In particular, the well region has the same shape, being smaller in size, as the drift layer in lateral directions. Further, all symmetry axis of the shapes in lateral directions, e.g. all mirror axis of the shapes in lateral directions, are the same. The symmetry axis and thus also the mirror axis are solely of a virtual nature.

According to the embodiment, the power semiconductor device comprises a first doped region of the first conductivity type and a second doped region of the second conductivity type.

The first doped region and the second doped region comprise or consist of a semiconductor material, which is, for example, the same material as the semiconductor material of the drift layer. Exemplarily, the first doped region comprises further first dopants. Exemplarily, the second doped region comprises further second dopants. For example, the further first dopants are n-type dopants and the further second dopants are p-type dopants, or vice versa.

Exemplarily, the further first dopants are the same dopants as the first dopants. Further, the further second dopants are exemplarily the same dopants as the second dopants.

Exemplarily, the drift layer has a homogeneous doping concentration so that a maximum doping concentration corresponds to a mean doping concentration. For example, a maximum doping concentration of the first doped region is higher than the maximum doping concentration of the drift layer. Exemplarily, the maximum doping concentration of the first doped region is at least one or at least two orders of magnitude higher than the maximum doping concentration of the drift layer. For example, the maximum doping concentration of the drift layer is at least 1·10¹⁴ cm⁻³ and at most 1·10¹⁷ cm⁻³.

For example, a maximum doping concentration of the second doped region is higher than a maximum doping concentration of the well region. Exemplary, the maximum doping concentration of the second doped region is at least one or two orders of magnitude higher than the maximum doping concentration of the well region.

For example, the maximum doping concentration of the first doped region is at least 1·10¹⁶ cm⁻³ and at most 1·10²¹ cm⁻³. For example, the maximum doping concentration of the second doped region is at least 1·10¹⁷ cm⁻³ and at most 1·10²¹ cm⁻³.

In particular, at least a part of the first doped region form a source region of the power semiconductor device. The source region is an area, where charge carriers, e.g. electrons or holes, are injected into the well region.

According to the embodiment of the power semiconductor device, the well region, the first doped region and the second doped region are provided at a first side of the power semiconductor device.

The well region, the first doped region and the second doped region each extend in vertical direction from the first side up to a predetermined depth. The well region can have a first depth, the first doped region can have a second depth and the second doped region can have a third depth.

Exemplary, the first depth is larger than the second depth and the third depth. For example, the third depth is larger than the second depth or alternatively, the second depth and the third depth are equal. For example, the second depth is at least 0.1 µm and at most 0.5 µm. For example, the third depth is at least 0.3 µm and at most 3 µm.

For example, a first main surface at the first side of the power semiconductor device is formed flat. The first main surface extends parallel to the lateral directions. This is to say that a top surface of the well region, a top surface of the first doped region and a top surface of the second doped region are part of the first main surface.

According to the embodiment of the power semiconductor device, the first doped region and the second doped region are spaced apart from the drift layer by the well region. The first doped region and the second doped region are exemplarily embedded in the well region. This is to say that outer surfaces of the first doped region and the second doped region are covered by the well region, except the top surfaces of the first doped region and the second doped region.

For example, the top surfaces of the first doped region and the second doped region are at least in regions externally contactable in an electrical conductive manner.

According to the embodiment of the power semiconductor device, the second doped region is completely surrounded by the first doped region in lateral directions.

In top view, along the vertical direction, the first doped region has in lateral directions, for example, a polygonal shape, such as a triangular shape, a quadrangular shape or a hexagonal shape. For example, an outer circumference of the first doped region has the polygonal shape in lateral directions. In particular, the first doped region has the same shape, being smaller in size, as the drift layer and/or the well region in lateral directions.

Exemplarily, the outer circumference of the drift layer completely surrounds the outer circumference of the well region in lateral directions. For example, the outer circumference of the well region completely surrounds the outer circumference of the first doped region in lateral directions.

That the second doped region is completely surrounded by the first doped region in lateral directions means here and in the following that, for example, the second doped region is embedded in the first doped region. This is to say that outer surfaces, in particular all side surfaces, of the second doped region are covered at least partially by the first doped region, except the top surfaces and bottom surfaces of the second doped region. In particular, the side surfaces of the second doped region are at least partially in direct and immediate contact to the first doped region.

According to the embodiment of the power semiconductor device, the second doped region comprises at least two parts, which are spaced apart from one another in lateral directions by the first doped region. In particular, each part is completely surrounded by the first doped region in lateral directions, which means here and in the following that, for example, each part is embedded in the first doped region. This is to say that outer surfaces, in particular all side surfaces, of each part are covered at least partially by the first doped region, except the top surfaces and bottom surfaces of each part.

Exemplarily, a distance of directly neighbouring parts is at least 0.1 µm and at most 1 µm. Exemplarily, the distance is defined between the side surfaces facing one another of directly neighbouring parts.

This is, for example, that the power semiconductor device is a three dimensional, 3D, SiC MISFET, in particular a 3D SiC MOSFET.

With such second doped region comprising the two parts being spaced apart from one another via the first doped region, leads to a superior performance of such a power semiconductor device. Both a reduction in terms of a peak drain current density and in terms of the maximum junction temperature can be achieved.

Advantageously, with such discontinuous parts, a current path into a narrow and highly resistive region is limited - which is very effective at a higher junction temperature. This allows to drastically reduce the junction temperature and improve the reliability of an oxide and packaging materials.

The source region of such a power semiconductor device features advantageously a first region with discontinuous parts, each having exemplarily a p+ implantation profile, which provides an improved trade-off between conduction losses and short circuit withstand time.

According to a further embodiment of the power semiconductor device, the first doped region comprises at least two zones, a first zone and a fourth zone.

According to a further embodiment of the power semiconductor device, the second doped region is completely surrounded in lateral directions by the first zone. Exemplarily, an outer circumference of the first zone in lateral directions is formed by the outer circumference of the first doped region.

According to a further embodiment of the power semiconductor device, the fourth zone is arranged in a central region of the power semiconductor device in lateral directions. In particular, the fourth zone is arranged in a region of a high symmetry point, where all the symmetry axis cross one another in lateral directions. This is that the fourth zone is completely surrounded in lateral directions by the first zone. Further, the fourth zone is arranged exemplarily between neighbouring parts in lateral directions.

According to a further embodiment of the power semiconductor device, a maximum doping concentration of the first zone is different from a maximum doping concentration of the fourth zone. For example, the maximum doping concentration of the first zone is smaller than the maximum doping concentration of the fourth zone, or vice versa. For example, the maximum doping concentration of the first zone is at least one or two orders of magnitude smaller than the maximum doping concentration of the fourth zone, or vice versa.

In particular, the second doping region needs to be high enough for a formation of a sufficiently good ohmic contact to a contact metal layer, e.g. a top metal layer.

According to a further embodiment of the power semiconductor device, the second doped region comprises a further part. Exemplarily, the further part is spaced apart from each part by the first doped region in lateral directions.

According to a further embodiment of the power semiconductor device, the further part is arranged in the central region of the power semiconductor device in lateral directions.

According to a further embodiment of the power semiconductor device, the further part is completely surrounded in lateral directions by the fourth zone.

In top view, along the vertical direction, the further part has in lateral directions, for example, a polygonal shape, such as a triangular shape, a quadrangular shape or a hexagonal shape. For example, an outer circumference of the further part has the polygonal shape in lateral directions. In particular, the further part has the same shape, being smaller in size, as the drift layer and/or the well region.

Furthermore, in top view, along the vertical direction, the fourth zone has in lateral directions, for example, a polygonal shape, such as a triangular shape, a quadrangular shape or a hexagonal shape. For example, an outer circumference of the fourth zone has the polygonal shape in lateral directions. In particular, the fourth zone has the same shape, being smaller in size, as the drift layer and/or the well region in lateral directions.

Exemplarily, the outer circumference of the fourth zone completely surrounds the outer circumference of the further part in lateral directions.

According to a further embodiment of the power semiconductor device, the parts are arranged on grid points of a grid. The grid is exemplarily a polygonal grid, such as a triangular grid, a quadrangular grid or a hexagonal grid.

According to a further embodiment of the power semiconductor device, the grid points are connected by grid lines of the grid and the parts extend at least partially along the grid lines. In particular, at least some regions of the grid lines are free of the parts. For example, the regions of the grid lines are free of the parts, where the parts are spaced apart from one another in lateral directions by the first region.

The grid, the grid points as well as the grid lines are solely of a virtual nature.

According to a further embodiment of the power semiconductor device, the grid is a quadrangular grid or the grid is a hexagonal grid. A form of the grid corresponds, for example, to a shape, in particular a common shape, of the drift layer, the well region, the first region and/or the second region. In particular, the grid is a regular grid.

According to a further embodiment of the power semiconductor device, each of the parts is arranged on at least one grid point.

According to a further embodiment of the power semiconductor device, each of the parts comprises at least two branches. Exemplarily, each of the parts extends along these branches, i.e. each of the parts is formed of these branches.

According to a further embodiment of the power semiconductor device, the least two branches extends at least partially along at least two of the grid lines of the respective grid point.

According to a further embodiment of the power semiconductor device, the first doped region comprises at least four zones, the first zone, the fourth zone, a second zone and a third zone.

According to a further embodiment of the power semiconductor device, the second doped region is completely surrounded in lateral directions by the first zone.

According to a further embodiment of the power semiconductor device, the second zone is completely surrounded in lateral directions by the first zone.

In top view, along the vertical direction, the second zone has in lateral directions, for example, a polygonal shape, such as a triangular shape, a quadrangular shape or a hexagonal shape. For example, an outer circumference of the second zone has the polygonal shape in lateral directions. In particular, the second zone has the same shape, being smaller in size, as the first zone in lateral directions.

Exemplarily, the outer circumference of the second zone completely surrounds the outer circumference of the second doped region in lateral directions. Further, the outer circumference of the first zone completely surrounds the outer circumference of the second zone in lateral directions.

According to a further embodiment of the power semiconductor device, the third zone is arranged in lateral directions between end regions of the parts facing one another. In particular, the third zone is arranged in lateral directions between the fourth zone and the second zone.

Exemplarily, the maximum doping concentrations of all the zones are equal to one another within the production tolerance limits.

Exemplarily, maximum doping concentrations of at least two of the zones are different from one another. For example, the maximum doping concentrations of all the zones are different from one another. The maximum doping concentrations of different zones differ from one another by at most 90 %, e.g. approximately 80 %.

Exemplarily, the maximum doping concentrations of the second zone and the third zone are equal to one another and the maximum doping concentrations of the first zone and the fourth zone are equal to one another. In this case, the maximum doping concentration of the second zone and the third zone are smaller than the maximum doping concentration of the first zone and the fourth zone.

Exemplarily, the maximum doping concentrations of the first zone, the second zone and the fourth zone are equal to one another. For example, the maximum doping concentration of the third zone is smaller than the maximum doping concentration of the first zone, the second zone and the fourth zone.

For example, the maximum doping concentrations of the first zone and the fourth zone are equal to one another. Exemplarily, the maximum doping concentration of the third zone is smaller than the maximum doping concentration of the second zone. Exemplarily, the maximum doping concentration of the second zone is smaller than the maximum doping concentration of the first zone and the fourth zone.

Exemplarily, the maximum doping concentrations of the first zone, the second zone and the fourth zone are equal to one another. Further, each maximum doping concentration of the first zone, the second zone and the fourth zone is, for example, approximately 20 % of the maximum doping concentration of the third zone. For example, the maximum doping concentration of the third zone is about 1·10²⁰ cm⁻³, in such a configuration. Such a doping configuration shows advantageously an improved trade-off between conduction loss and short circuit withstand time.

In particular, the presence of a low doped zone allows to better exploit the electrostatic potential effect, i.e. increased depletion region extension, which can pinch off the total current during short circuit operation. Further, the presence of a low doped zone advantageously does not affect the threshold voltage of the power semiconductor device.

According to a further embodiment of the power semiconductor device, a maximum doping concentration of the further part is different from a maximum doping concentration of the parts. For example, the maximum doping concentration of the parts are smaller than the maximum doping concentration of the further part, or vice versa.

For example, the maximum doping concentration of the further part is at least one or two orders of magnitude higher than the maximum doping concentration of the parts, or vice versa.

According to a further embodiment, the power semiconductor device comprises a semiconductor body having the first main surface at the first side and a second main surface at a second side opposite the first side.

According to a further embodiment, the power semiconductor device comprises a gate insulator arranged at the first main surface.

The gate insulator comprises, for example, an electrical insulating material, such as an electrical insulating oxide or high k-dielectrics. SiO₂ has a dielectric constant of 3.9 and "high k" dielectric materials are referred to as having a dielectric constant k > 3.9.

Advantageously, by predetermine an overlap area in lateral directions of the gate insulator and the first region, in particular the first zone, a resistance of the first region, in particular the first zone, can be predetermined. This is that the resistance of the first region, in particular the first zone, is predetermined dependent on the overlap area in lateral directions of the gate insulator and the first region, in particular the first zone.

According to a further embodiment, the power semiconductor device comprises a gate electrode separated from the semiconductor body by the gate insulator.

The gate electrode comprises or consists of a metal. For example, the gate contact is, at least in regions, externally contactable in an electrical conductive manner. Further, the gate contact is exemplarily embedded in the gate insulator. This is to say that the gate insulator covers all outer surfaces of the gate contact, except the region for external contacting.

According to a further embodiment of the power semiconductor device, the semiconductor body comprises the drift layer, the well region, the first doped region and the second doped region.

According to a further embodiment, the power semiconductor device comprises a top metal layer arranged at the first main surface. For example, the top metal layer is provided on the source region, i.e. the first doped region and the second doped region at the first side. For example, the top metal layer is provided on the first main surface.

According to a further embodiment of the power semiconductor device, the top metal layer at least partially overlaps in lateral directions with the first doped region and the second doped region. Exemplarily, the top metal layer is in direct contact to the first doped region and the second doped region on their top surfaces.

According to a further embodiment of the power semiconductor device, the top metal layer overlaps in lateral directions at least partially with at least two or all of the parts, or the top metal layer overlaps in lateral directions completely with the further part.

If the top metal layer overlaps in lateral directions completely with the further part, all parts are free of the top metal layer, for example. The parts are in this case floating parts. Otherwise, if the top metal layer overlaps with at least some of the parts, these pars are grounded parts, for example.

Exemplarily, the top metal layer overlaps in lateral directions at least partially with the fourth zone. This is, for example, that the first zone, the second zone and the third zone do not overlap with the top metal layer in lateral directions.

In particular, the top metal layer overlaps in lateral directions with the fourth zone to a great extent. "To a great extent" means here that the top metal layer covers at least 50 % or at least 70 % of the top surface of the fourth zone.

According to a further embodiment, the power semiconductor device comprises a substrate layer. Exemplarily, the substrate layer of the first conductivity type is arranged on the drift layer at the second side opposite the first side. For example, the maximum doping concentration of the drift layer is at least two orders of magnitude higher, exemplarily five times higher, than a maximum doping concentration of the drift layer.

According to a further embodiment, the power semiconductor device comprises a back metal layer arranged at the second main surface. For example, the back metal layer is provided on the second main surface of the drift layer at the second side. For example, the back metal layer covers the second main surface completely.

The top metal layer and/or the back metal layer comprises, for example, a metal or consists of a metal. For example, the top metal layer and/or the back metal layer is an electrode being externally contactable in an electrical conductive manner.

According to a further embodiment of the power semiconductor device, the substrate layer is arranged between the back metal layer and the drift layer.

A further embodiment relates to a method for producing a power semiconductor device, in particular, a power semiconductor device described herein above. Therefore, the features as described in connection with the method are also applicable for the power semiconductor device and vice versa.

According to an embodiment of the method, a drift layer of a first conductivity type is provided. In particular, the drift layer is an epitaxial semiconductor layer. For example, a base material of the drift layer is grown epitaxially. The base material is further doped with the first dopants.

According to the embodiment of the method, the well region of a second conductivity type being different from the first conductivity type is produced at a first side. Exemplarily the well regions are produced within the drift layer, i.e. the base material, by a doping process. For example, the second dopants are introduced into the drift layer. Due to the introduction of the second dopants into the drift layer, the well regions are exemplarily generated.

According to the embodiment of the method, a first doped region of the first conductivity type and a second doped region of the second conductivity type are produced at the first side. Exemplarily the source region comprising the first doped region and the second doped region is produced within the drift layer by a further doping process.

For example, the source region is produced by introducing at least one of the further first dopants or the further second dopants into the drift layer. The term "at least one of the further first dopants or further second dopants are introduced" shall cover cases, in which either the further first dopants are introduced, or the further second dopants are introduced, or the further first dopants and the further second dopants are introduced.

The first dopants, the further first dopants, the second dopants and/or the further second dopants are, for example, incorporated within the drift layer, e.g. by an ion implantation process.

According to the embodiment of the method, a mask is used for generating the at least one first doped region such that an interface between the at least one first doped region and the at least one second doped region is structured. In particular, the mask is an implantation mask configured to confine an implantation region of the further first dopants.

According to a further embodiment of the method, a further mask is used for generating the at least one second doped region. In particular, the further mask is a further implantation mask configured to confine an implantation region of the further second dopants.

With such a method, no change in processing is required and advantageously, no extra masks are required to produce the parts of the second doped region - in comparison to producing a conventional SiC MISFET. Thus, it is advantageously solely necessary to re-draw the implantation masks for the first dopants and the second dopants.

According to a further embodiment of the method, a self-aligned process is used for generating the at least one second doped region. With such a method the structured interface can be defined in particular simple and precise.

The accompanying Figures are included to provide a further understanding. In the Figures, elements of the same structure and/or functionality may be referenced by the same reference signs. It is to be understood that the embodiments shown in the Figures are illustrative representations and are not necessarily drawn to scale.
Figures 1, 2, 3 and 4 each exemplarily and schematically shows a schematic view of a power semiconductor device according to prior art.
Figures 5, 6, 7, 8, 9, 10, 11, 12 and 13 each schematically shows a schematic top view of a power semiconductor device according to an exemplary embodiment.
Figures 14, 15, 16 and 17 each shows an exemplary diagram of simulated performance data, inter alia, of a power semiconductor device according to an exemplary embodiment.

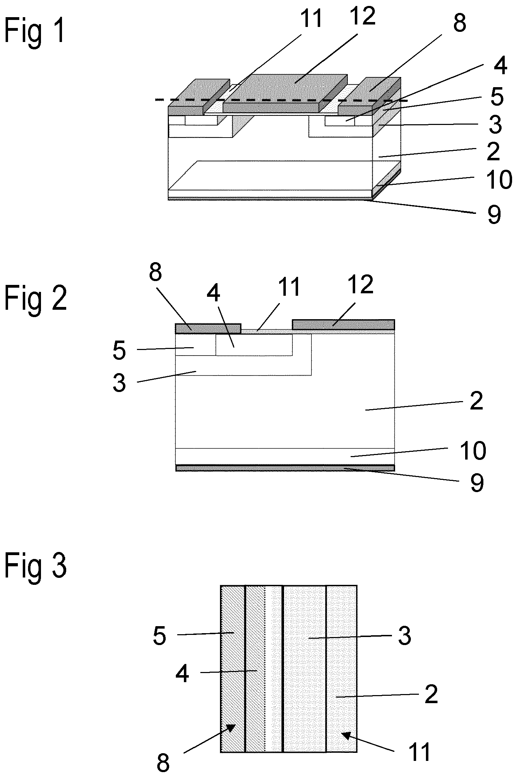

The prior art power semiconductor device according to Figures 1 and 2 comprises a back metal layer 9, a substrate layer 10 and a drift layer 2 being stacked above one another in the order indicated in vertical direction. The drift layer 2, and in particular the substrate layer 10, comprises a semiconductor material being formed of SiC.

The prior art power semiconductor device further comprises two well regions 3 of a second conductivity type being different from the first conductivity type at a first side of the drift layer 2. The well regions 3 are spaced apart from one another in lateral directions by the drift layer 2.

For example, the first conductivity type is an n-type conductivity. For example, the second conductivity type is a p-type conductivity.

The well region 3s are produced, for example, within the drift layer 2 by a doping process. For example, second dopants are introduced in the drift layer 2 and thereby generating the well regions 3 up to a first depth.

Each well region 3 comprises a first doped region 4 of the first conductivity type and a second doped region 5 of the second conductivity type.

A top surface of the well regions 3, a top surface of the first doped regions 4, a top surface of the second doped regions 5 and a top surface of the drift layer 2 are arranged within a common plane, i.e. a first main surface.

A top metal layer 8 is arranged on the first main surface, covering the top surface of the second doped region 5, e.g. completely, and at least a part of the top surface of the first doped region 4. Further, a gate insulator 11 is arranged on the top surface between top metal layers 8 arranged on different well regions 3. This is that the gate insulator 11 covers the top surface of the drift layer 2, e.g. completely, the top surfaces of the well region 3, e.g. completely, and at least a part of the top surface of the first doped region 4. A gate electrode 12 is arranged on the gate insulator 11 on the first side facing away from the drift layer 2. The gate electrode 12 overlaps in lateral directions with the drift layer 2, e.g. completely, and at least partially with the well region 3.

The prior art power semiconductor device according to Figure 3 is a top view, along the vertical direction being perpendicular to lateral directions. The lateral directions extend along a main extension plane of the drift layer 2.

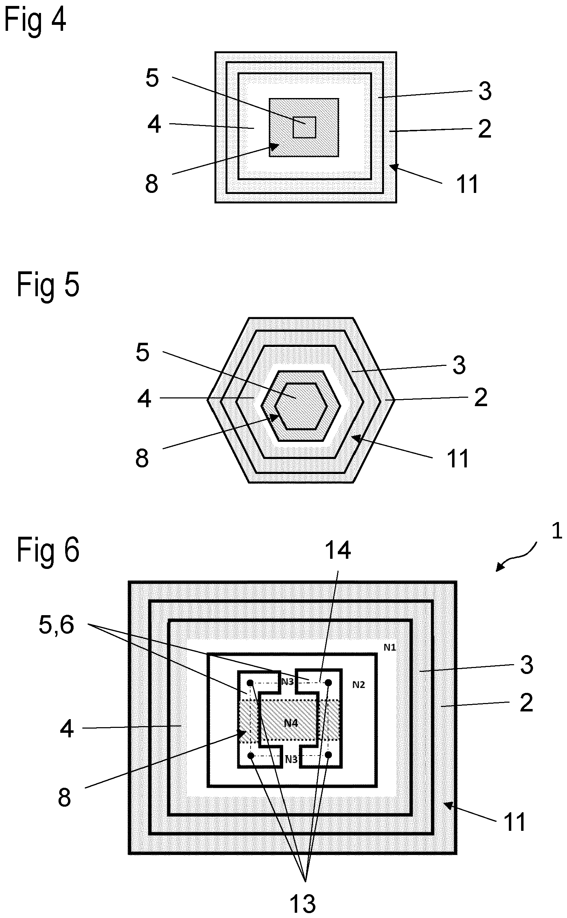

The top metal layer 8 is depicted in Figure 3 as well as in the following Figures 4 to 13 as a hatched region (lines) and the gate insulator 11 is depicted in Figure 3 as well as in the following Figures 4 to 13 as a shaded region (dots).

In particular, the prior art power semiconductor device according to Figure 3 has a standard stripe topology, where the well region 3 as well as the first doped region 4 and the second doped region 5 extend in a main extension direction.

The prior art power semiconductor devices according to Figures 4 and 5 each are a top view, along the vertical direction. In comparison to Figure 3, the prior art power semiconductor device according to Figure 4 has an array-based cell topology and the prior art power semiconductor device according to Figure 5 has a hexagonal cell topology.

The power semiconductor device 1 according to the exemplary embodiment of Figure 6 has a drift layer 2, a well region 3, a first doped region 4 and a second doped region 5. According to this exemplary embodiment, the second doped region 5 comprises at least two parts 6, namely a first part and a second part, which are spaced apart from one another in lateral directions by the first doped region 4.

An outer circumference of the drift layer 2, an outer circumference of the well region 3 and an outer circumference of the first doped region 4 each has a quadrangular shape in lateral directions. Further, all symmetry axis such as all mirror axis of the shapes in lateral directions of the drift layer 2, the well region 3 and the first region are the same.

The outer circumference of the drift layer 2 completely surrounds the outer circumference of the well region 3 in lateral directions. The outer circumference of the well region 3 completely surrounds the outer circumference of the first doped region 4 in lateral directions.

The first doped region 4 comprises a first zone N1, a second zone N2, two third zones N3 and a fourth zone N4. An outer circumference of the first zone N1 is represented by the outer circumference of the first doped region 4. Further, an outer circumference of the second zone N2 also has the quadrangular shape in lateral directions. The outer circumference of the first zone N1 completely surrounds the outer circumference of the second zone N2 in lateral directions. Further, the outer circumference of the second zone N2 completely surrounds the first doped region 4 as well as the third zones N3 and the fourth zone N4 in lateral directions.

The first part and the second part of the parts 6 of the second doped region 5 are arranged on grid points 13 of a grid, wherein the grid is a quadrangular grid, 2 by 2 grid points 13 in size. The grid points 13 are connected by grid lines of the grid. The grid points 13 and the grid lines 14 are of virtual nature and are drawn in Figure 6 solely for better comprehensibility.

Each part 6 is arranged on two directly neighboring grid points 13. These two directly neighboring grid points 13 are connected by one of the grid lines 14, along which the respective part 6 extends completely, forming a branch of the part 6.

Furthermore, each of the parts 6 comprises additionally two branches extending perpendicular to the branch connecting the two directly neighboring grid points 13. This is that each of the additionally two branches extends partially along the grid line connecting two directly neighboring grid points 13 of different parts 6. The first doped region 4, in particular the third zone N3, is arranged in lateral directions between directly neighboring additional branches of directly neighboring different parts 6.

The fourth zone N4 is arranged in a central region of the power semiconductor device 1 in lateral directions, in particular, in a region of a high symmetry point, where all the symmetry axis of the shapes cross one another in lateral directions. This is that the fourth zone N4 is arranged between directly opposite branches of directly neighboring different parts 6.

A top metal layer 8 extends between directly opposite branches of directly neighboring different parts 6. The top metal layer 8 covers directly opposite branches of directly neighboring different parts 6 as well as the fourth region.

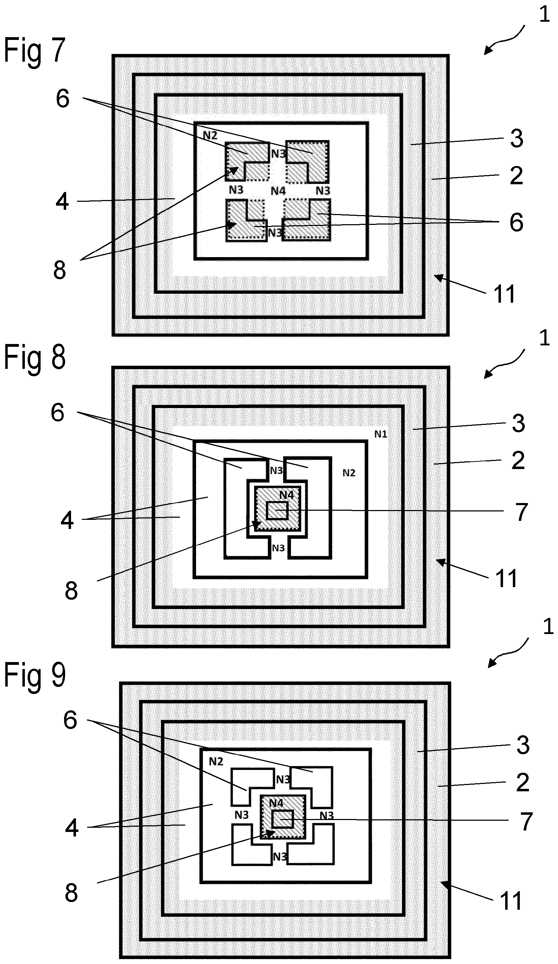

The power semiconductor device 1 according to the exemplary embodiment of Figure 7 has in contrast to the power semiconductor device 1 of Figure 6 a second doped region 5 comprising four parts 6. Each part 6 is arranged on one grid point 13. Further, each part 6 comprises two branches, wherein the branches extend partially along the two grid lines 14 of the corresponding grid point 13. Opposite branches of different directly neighboring parts 6 are spaced apart from one another in lateral directions. This is that the first doped region 4, in particular the third zones N3, is arranged between two directly neighboring branches of different directly neighboring parts 6 in lateral directions.

The power semiconductor device 1 according to Figure 7 has four top metal layers 8. Each top metal layer 8 covers one of the parts 6 completely in lateral directions. Each top metal layer 8 has a quadrangular shape in lateral directions such that each metal layer 8 also covers a part 6 of the fourth zone N4 in latera directions.

The power semiconductor device 1 according to the exemplary embodiment of Figure 8 has in contrast to the power semiconductor device 1 of Figure 6 a further part 7 of the power semiconductor device. The further part 7 is arranged in the central region of the power semiconductor device 1 in lateral directions.

The further part 7 is completely surrounded in lateral directions by the fourth zone N4, such that the further part 7 is spaced apart from each part 6 by the first doped region 4, in particular the fourth zone N4.

The top metal layer 8 according to Figure 8 does not cover the branches of the parts 6 in contrast to Figure 6. In Figure 8, the top metal layer 8 completely covers the further part 7 in lateral directions as well as partially covers the fourth zone N4 in lateral directions.

The power semiconductor device 1 according to the exemplary embodiment of Figure 9 has in contrast to the power semiconductor device 1 of Figure 7 a further part 7 and a top metal layer 8, analogously to Figure 8.

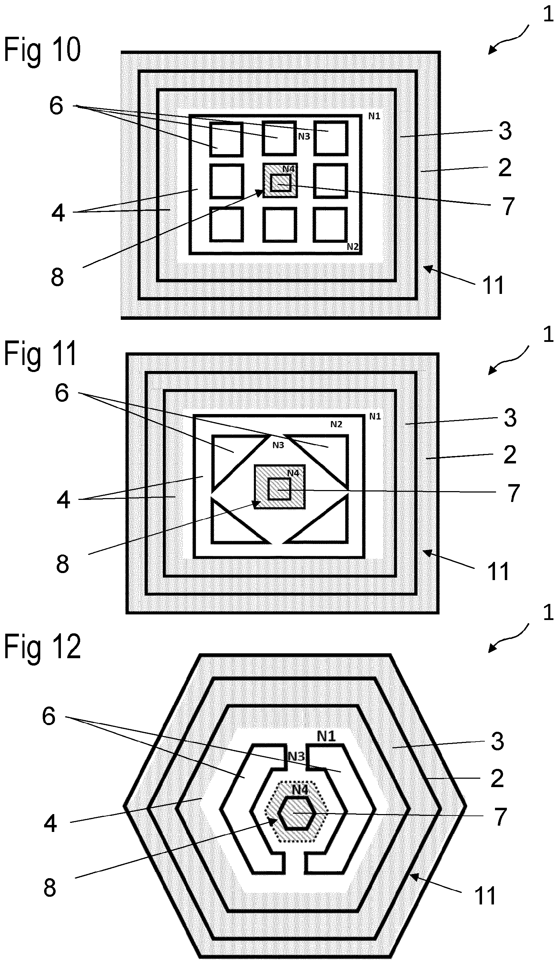

The power semiconductor device 1 according to the exemplary embodiment of Figure 10 has in contrast to the power semiconductor device 1 of Figure 9 eight parts 6. The grid has nine grid points 13, arranged equally along rows and columns, i.e. in a 3 by 3 matrix. The further part 7 is arranged on the central grid point 13. Each part 6 is arranged on one of the grid points arranged around the central grid point 13.

The power semiconductor device 1 according to the exemplary embodiment of Figure 11 has in contrast to the power semiconductor device 1 of Figure 9 parts 6, each of which has a triangular shape in lateral directions. Each triangular shape in lateral directions is in particular an orthogonal triangle. The orthogonal angle of each orthogonal triangle faces one corner of the shape of the first doped region 4.

The power semiconductor device 1 according to the exemplary embodiment of Figure 12 has in comparison to the power semiconductor device 1 of Figure 8 a drift layer 2, a well region 3, a first doped region 4 and a second doped region 5, which outer surfaces are each of a hexagonal shape.

Each part 6 is arranged on three grid points 13 of a grid being a hexagonal grid, i.e. having a size of six grid points 13.

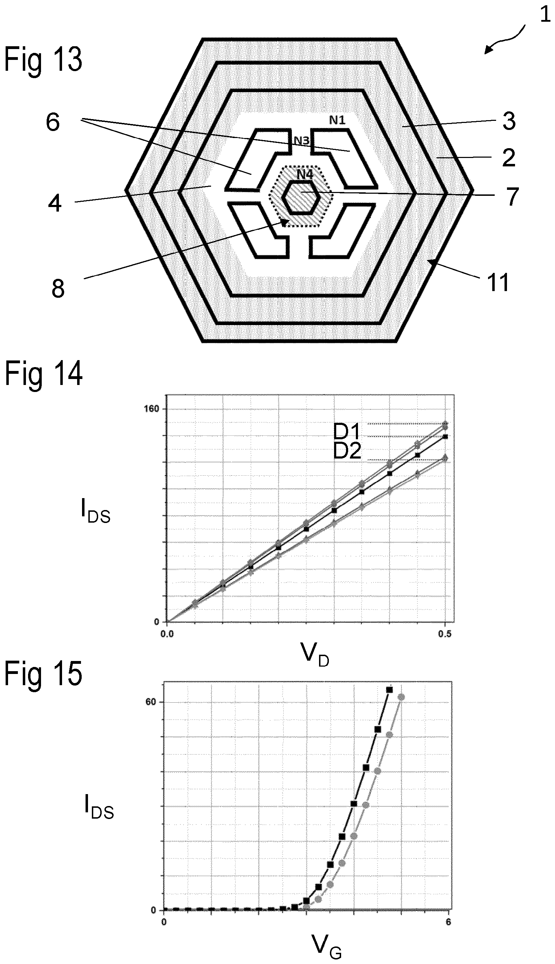

The power semiconductor device 1 according to the exemplary embodiment of Figure 13 has in comparison to the power semiconductor device 1 of Figure 9 has a drift layer 2, a well region 3, a first doped region 4 and a second doped region 5, which outer surfaces are each of a hexagonal shape.

Due to the hexagonal shape, the branches have an angle to one another different from being orthogonal.

A drain current density, I_{DS}, in amperes, A/cm², is depicted on the y-axis of the diagram according to Figures 14, 15 and 16. Furthermore, a drain voltage, V_{D}, in volt, V, is depicted on the x-axis in Figure 14. The three uppermost I-V curves correspond to a SiC MOSFET according to prior art.

The two bottommost I-V curves correspond to a power semiconductor device 1 being a SiC MISFET according to the exemplary embodiments, in particular to a power semiconductor device 1 according to Figure 7. The upper curve of the two bottommost I-V curves correspond to a distance between directly neighbouring parts 6 of 0.4 µm. The lower curve of the two bottommost I-V curves correspond to a distance between directly neighbouring parts 6 of 0.6 µm.

The values in the diagram in Figure 14 are simulated with a Gate-Source Voltage V_{GS} of 15 V and a temperature of 300 K.

A gate voltage, V_{G}, in volt, V, is depicted on the x-axis in Figure 15. The uppermost I-V curve corresponds to a SiC MOSFET according to prior art, e.g. Figure 3. The bottommost I-V curve corresponds to a power semiconductor device 1 according to Figure 7 with a distance between directly neighbouring parts 6 of 0.6 µm.

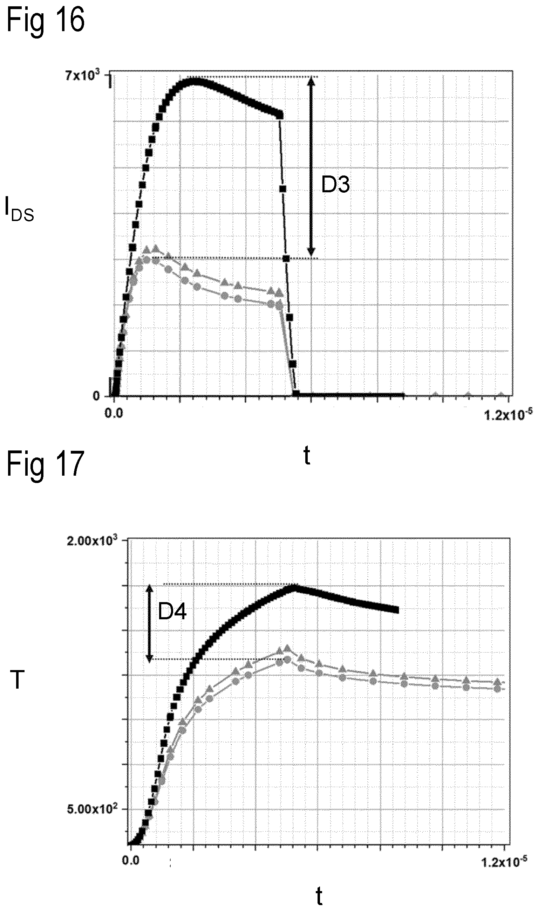

A time, t, in micro seconds, ps, is depicted on the x-axis Figure 16. The uppermost I-V curve corresponds to a SiC MOSFET according to prior art, e.g. Figure 3. The two bottommost I-V curve corresponds to a power semiconductor device 1 as already descried in connection with Figure 14.

A maximum junction temperature, T, in Kelvin, K, is depicted on the y-axis of the diagram according to Figure 17. Furthermore, time, t, in micro seconds, ps, is depicted on the x-axis Figure 17. The uppermost I-V curve corresponds to a SiC MOSFET according to prior art, e.g. Figure 3. The two bottommost I-V curve corresponds to a power semiconductor device 1 as already descried in connection with Figure 14.

A difference D1 indicated in Figure 14 is about 7 % and a difference D2 is about 12 %.

Further, a difference D3 indicated in Figure 16 is about 52 % and a difference D4 indicated in Figure 17 is about 25 %. As it can be observed the presence of the discontinuous parts 6 limit the current path into a narrow and highly resistive region which is very effective at higher junction temperature. This allows to drastically reduce the junction temperature and improve the reliability of the oxide and packaging materials.

### Reference Signs

- 1: power semiconductor device
- 2: drift layer
- 3: well region
- 4: first doped region
- 5: second doped region
- 6: part
- 7: further part
- 8: top metal layer
- 9: back metal layer
- 10: substrate layer
- 11: gate insulator
- 12: gate electrode
- 13: grid points
- 14: grid lines

- N1: first zone
- N2: second zone
- N3: third zone
- N4: fourth zone

- I_{DS}: drain current density
- V_{D}: drain voltage
- V_{G}: gate voltage
- T: temperature
- t: time

- D1...D4: differences

## Claims

1. A power semiconductor device (1), comprising
- a drift layer (2) of a first conductivity type,
- a well region (3) of a second conductivity type being different from the first conductivity type, and
- a first doped region (4) of the first conductivity type and a second doped region (5) of the second conductivity type, wherein
- the well region (3), the first doped region (4) and the second doped region (5) are provided at a first side of the power semiconductor device (1),
- the first doped region (4) and the second doped region (5) are spaced apart (6) from the drift layer (2) by the well region (3), and
- the second doped region (5) is completely surrounded by the first doped region (4) in lateral directions, and
- the second doped region (5) comprises at least two parts (6), which are spaced apart (6) from one another in lateral directions by the first doped region (4).

2. The power semiconductor device (1) according to claim 1, wherein
- the first doped region (4) comprises at least two zones, a first zone (N1) and a fourth zone (N4),
- the second doped region (5) is completely surrounded in lateral directions by the first zone (N1),
- the fourth zone (N4) is arranged in a central region of the power semiconductor device (1) in lateral directions, and
- a maximum doping concentration of the first zone (N1) is different from a maximum doping concentration of the fourth zone (N4).

3. The power semiconductor device (1) according to one of the claims 1 or 2, wherein
- the second doped region (5) comprises a further part (7), and
- the further part (7) is arranged in a central region of the power semiconductor device (1) in lateral directions.

4. The power semiconductor device (1) according to claims 2 and 3, wherein
- the further part (7) is completely surrounded in lateral directions by the fourth zone (N4).

5. The power semiconductor device (1) according to one of the claims 1 to 4, wherein
- the parts (6) are arranged on grid points (13) of a grid.

6. The power semiconductor device (1) according to claim 5, wherein
- the grid points (13) are connected by grid lines (14) of the grid and the parts (6) extend at least partially along the grid lines (14), and
- the grid is a quadrangular grid or the grid is a hexagonal grid.

7. The power semiconductor device (1) according to one of the claims 5 or 6, wherein
- each of the parts (6) is arranged on at least one grid point,
- each of the parts (6) comprises at least two branches, and
- the least two branches extends at least partially along at least two of the grid lines (14) of the respective grid point.

8. The power semiconductor device (1) according to one of the claims 2 to 7, wherein
- the first doped region (4) comprises at least four zones, the first zone (N1), the fourth zone (N4), a second zone (N2) and a third zone (N3),
- the second doped region (5) is completely surrounded in lateral directions by the first zone (N1),
- the second zone (N2) is completely surrounded in lateral directions by the first zone (N1), and
- the third zone (N3) is arranged in lateral directions between end regions of the parts (6) facing one another.

9. The power semiconductor device (1) according to one of the claims 3 to 8, wherein
- a maximum doping concentration of the further part (7) is different from a maximum doping concentration of the parts (6) .

10. The power semiconductor device (1) according to one of the claims 1 to 9, further comprising
- a semiconductor body having a first main surface at the first side and a second main surface at a second side opposite the first side,
- a gate insulator (11) arranged at the first main surface, and
- a gate electrode (12) separated from the semiconductor body by the gate insulator (11), wherein
- the semiconductor body comprises the drift layer (2), the well region (3), the first doped region (4) and the second doped region (5).

11. The power semiconductor device (1) according to claim 10, further comprising
- a top metal layer (8) arranged at the first main surface, wherein
- the top metal layer (8) at least partially overlaps in lateral directions with the first doped region (4) and the second doped region (5).

12. The power semiconductor device (1) according to claim 11, wherein
- the top metal layer (8) overlaps in lateral directions at least partially with at least two or all of the parts (6), or
- the top metal layer (8) overlaps in lateral directions completely with the further part (7).

13. The power semiconductor device (1) according to one of the claim 10 to 12, further comprising
- a substrate layer (10), and
- a back metal layer (9) arranged at the second main surface, wherein,
- the substrate layer (10) is arranged between the back metal layer (9) and the drift layer (2).

14. Method for producing a power semiconductor device (20), comprising:
- proving a drift layer (1) of a first conductivity type,
- producing at least one well region (2) of a second conductivity type being different from the first conductivity type at a first side, and
- producing a first doped region (3) of the first conductivity type and a second doped region (4) of the second conductivity type at the first side, wherein,
- a mask is used for generating the at least one first doped region (3), such that an interface between the at least one first doped region (3) and the at least one second doped region (4) is structured.

15. Method for producing a power semiconductor device (20) according to claim 14, wherein
- a further mask is used for generating the at least one second doped region (4), or
- a self-aligned process is used for generating the at least one second doped region (4).
